Europäisches Patentamt

European Patent Office

Office européen des brevets

(11) Veröffentlichungsnummer: **0 579 857 A1**

# (12) EUROPÄISCHE PATENTANMELDUNG

(21) Anmeldenummer: **92112629.8**

(22) Anmeldetag: **23.07.92**

(51) Int. Cl.5: **H03K 3/78**

(43) Veröffentlichungstag der Anmeldung:
**26.01.94 Patentblatt 94/04**

(84) Benannte Vertragsstaaten:
**DE FR GB**

(71) Anmelder: **INTERNATIONAL BUSINESS MACHINES CORPORATION**

**Armonk, NY 10504(US)**

(72) Erfinder: **Staiger, Dieter Ernst**
**Falkenstr. 28**
**W-7039 Weil im Schönbuch(DE)**

(74) Vertreter: **Mönig, Anton, Dipl.-Ing.**
**IBM Deutschland Informationssysteme GmbH,**
**Patentwesen und Urheberrecht**
**D-70548 Stuttgart (DE)**

(54) **Verfahren zur computergesteuerten Erzeugung von Impulsintervallfolgen mit Abschnitten sich wiederholender Impulsintervalle.**

(57) Verfahren und Anordnung zur computergesteuerten Erzeugung von Impulsintervallfolgen mit Abschnitten sich wiederholender Impulsintervalle.

Ein Pre-Prozessor (1) liefert sequentiell an einen Revolver-Prozessor (2) Daten zur Kennzeichnung der Anzahl und Zeitdauer unmittelbar aufeinanderfolgender, gleicher Impulsintervalle und Daten zur Kennzeichnung der Anzahl von Wiederholungen eines Abschnittes von Impulsintervallen innerhalb einer Impulsintervallfolge unter Markierung des ersten und letzten Impulsintervalles innerhalb des zu wiederholenden Abschnittes.

Im Revolver-Prozessor (2) erfolgt ein taktgesteuerter, sequentieller Umlauf der vorgegebenen Daten in n-Stufen (n = 1, 2, 3, ... bis n). Der Revolver-Prozessor (2) weist eine Dateneingabestation an der ersten und eine Datenausgabestation an der n-ten Stufe auf. Die durch taktgesteuerten Umlauf die Ausgabestation erreichenden Daten werden (über einen Post-Prozessor) an einen Impulsintervallgenerator zur Erzeugung der Impulsintervallfolgen geliefert.

Beim Auftreten einer Kennzeichnung für den Beginn eines zu wiederholenden Abschnittes in der Ausgabestation wird der taktgesteuerte Umlauf unterbrochen, wonach prozessorgesteuert die Stufen mit den Daten vom ersten bis zum letzten Impulsintervall des zu wiederholenden Abschnittes entsprechend der Anzahl der Wiederholungen zyklisch durchlaufen werden. Dabei werden für jede durchlaufende Stufe deren Daten an der Ausgabestation an den Impulsintervallgenerator (4) geliefert. Nach Beendigung des zyklischen Durchlaufes wird die Dateneingabe an der Eingabestation des Revolver-Prozessors (2) und der Umlauf der Daten fortgesetzt.

Der Post-Prozessor (3) generiert aus den Angaben des Revolver-Prozessors (2) die Werte für aufeinanderfolgende Impulsintervalle zur Steuerung des Impulszyklusgenerators.

Bei der Durchführung des Verfahrens treten nach einer Anfangsphase zeitaufwendige Speicherzugriffszeiten nicht mehr in Erscheinung.

EP 0 579 857 A1

FIG. 1

FIG. 2

Die Erfindung betrifft ein Verfahren zur computergesteuerten Erzeugung von Impulsintervallen mit Abschnitten sich wiederholender Impulsintervalle.

Ein derartiges Verfahren ist z. B. in der deutschen Patentschrift 27 46 743 des Anmelders beschrieben (Aktenzeichen des Anmelders: GE 977 024).

Das wesentliche des in dieser Patentschrift beschriebenen Verfahrens liegt darin, daß zwischen den zu erzeugenden Impulsintervallen keine Totzeiten auftreten. Die Länge der Impulsintervalle wird durch einen Abwärtszähler vorgegeben. Vor Ablauf des Abwärtszählvorganges (also vor Erreichung des Standes "0") wird der Abwärtszähler mit einem neuen Wert (für den nächstenImpulszyklus) geladen, so daß der neue Abwärtszählvorgang unmittelbar an den vorhergehenden anschließt.

Bei der Implementierung dieses Verfahrens wird üblicherweise von einem Prozessor Gebrauch gemacht. Die meisten Prozessoren arbeiten nach dem sogenannten "Von Neumann Prinzip": mit den in einem (Programm-)Speicher enthaltenen Instruktionen wird ein Steuerwerk zu deren Ausführung beaufschlagt. Nach Ausführung einer Instruktion wird wieder auf eine neue Adresse des Programmspeichers verzweigt, an der die nächste Instruktion gespeichert ist, etc.

Die Zykluszeit des Prozessors wird in Hochgeschwindigkeitsrechnern ca. 50 % durch die Speicherzugriffszeit und zu ca. 50 % durch die Verarbeitungszeit des Steuerwerkes bestimmt.

Bei der Erzeugung von Impulsintervallfolgen, insbesondere für das Austesten schneller Speicher und Logikschaltungen, ist es erforderlich, zeitlich äußerst kurze Impulsintervalle zu erzeugen (in denen die Testpulse zu plazieren sind).

Es ist Aufgabe der Erfindung, Impulsintervallfolgen mit Abschnitten sich zyklisch wiederholender Impulsintervalle kürzester Impulsdauer (z. B. < 10 nsec) zu erzeugen.

Diese Aufgabe der Erfindung wird durch die im Anspruch 1 angegebenen Maßnahmen gelöst. Vorteilhafte Weiterbildungen der Erfindung sind den Unteransprüchen zu entnehmen.

Durch die Erfindung wird es quasi möglich, die Verarbeitungszeit des Steuerwerks in einem Prozessor einzusparen. Damit liegt die Zeitersparnis bei ca. 50 %. Sie ergibt sich nach einer Anlaufphase dadurch, daß die zur Verarbeitung erforderlichen Maßnahmen in einer vom Prozessor getrennten Einheit gleichzeitig mit den Speicherzugriffen im Prozessor erfolgen.

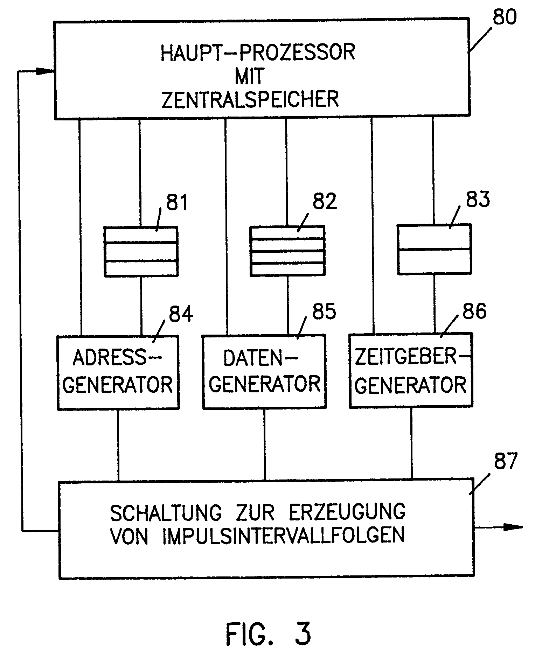

Nach dem Stand der Technik gibt es, wie in Fig. 3 dargestellt, Testsysteme, die neben einem Haupt-Prozessor 80 mit einem Zentralspeicher auch Sub-Speicher 81, 82, 83 aufweisen. Der Haupt-Prozessor 80 ist jeweils direkt und über einen Sub-Speicher mit einem Adreß- (84), Daten- (85) und Zeitgeber-Generator (86) verbunden, die ihrerseits mit einer Schaltung 87 zur Erzeugung von Impulsintervallfolgen verbunden sind.

In den Sub-Speichern sind verschiedene, spezielle Instruktionsfolgen gespeichert. Die Generatorschaltung 84, 85 und 86 erhält ihre Information zu einem Teil direkt aus dem Zentralspeicher (allgemeinen Angaben, z. B. Programm-Startadressen, Start, Stopp) und zu einem anderen Teil (spezielle Angaben, z. B. Impulszeitrelation` Intervallzeit, ALU-Op-Codes - ALU = arithmetisch-logische Einheit) aus den entsprechenden Sub-Speichern. Das Vorsehen von Sub-Speichern mit jeweils verschiedenen, speziellen Instruktionsfolgen bedingt einen großen programmiertechnischen Vorteil: Die verschiedenen Instruktionsfolgen in den Sub-Speichern können leicht untereinander kombiniert werden.

In diesem Zusammenhang sei jedoch auch darauf hingewiesen, daß die Zwischenschaltung eines Sub-Speichers eine weitere Zeitverzögerung bedingt.

Ausführungsbeispiele der Erfindung sind in den Zeichnungen dargestellt und werden im folgenden näher beschrieben. Es zeigen:

Fig. 1     eine schematische Darstellung einer zu erzeugenden Folge von sich wiederholenden Impulsintervallen;

Fig. 2     eine schematische Darstellung zur computergesteuerten Erzeugung einer Impulsintervallfolge gemäß Fig. 1 unter Verwendung eines Pre-Prozessors, eines sogenannten Revolver-Prozessors, eines Post-Prozessors und eines Impulszyklusgenerators;

Fig. 3     eine Übersicht eines Systems nach dem Stand der Technik mit einem Haupt-Prozessor und Sub-Speichern;

Fig. 4A    eine schematische Darstellung zum Funktionsablauf des Revolver-Prozessors zur Taktzeit t1;

Fig. 4B    eine schematische Darstellung zum Funktionsablauf des Revolver-Prozessors unter Berücksichtigung der Taktzeiten t1, t2, t3;

Fig. 4C    eine schematische Darstellung zum Funktionsablauf des Revolver-Prozessors unter Berücksichtigung der Taktzeiten t1 bis tn mit erstmals erfolgender Ausgabe von Daten an den Post-Prozessor zu Beginn einer vielfachen Wiederholung einer drei Datensätze umfassenden Folge;

Fig. 4D    eine schematische Darstellung zum Funktionsablauf des Revolver-Prozessors zu einem auf die Darstellung in Fig. 4A nachfolgenden Zeittakt;

Fig. 4E    eine schematische Darstellung zum Funktionsablauf des Revolver-Prozessors zu einem auf die Darstellung in Fig. 4D nachfolgenden Zeittakt;

Fig. 4F eine schematische Darstellung zum Funktionsablauf des Revolver-Prozessors zu einem auf die Darstellung in Fig. 4E nachfolgenden Zeittakt;

Fig. 5A eine schematische Darstellung vom Datenfluß im Post-Prozessor mit einer Datenausgabe an den Impulszyklusgenerator zur Erzeugung der ersten aufeinanderfolgenden gleichen Impulsintervalle der Zeitdauer T1;

Fig. 5B eine schematische Darstellung des Datenflusses im Post-Prozessor mit einer auf die Darstellung in Fig. 5A anschließenden Datenausgabe an den Impulszyklusgenerator zur Erzeugung weiterer aufeinanderfolgender gleicher Impulsintervalle der Impulsdauer T2;

Fig. 5C eine funktionelle Darstellung des Post-Prozessors;

Fig. 6 eine schematische Darstellung zur Synchronisation des aus Pre-, Revolver- und Post-Prozessor bestehenden Gesamtsystems.

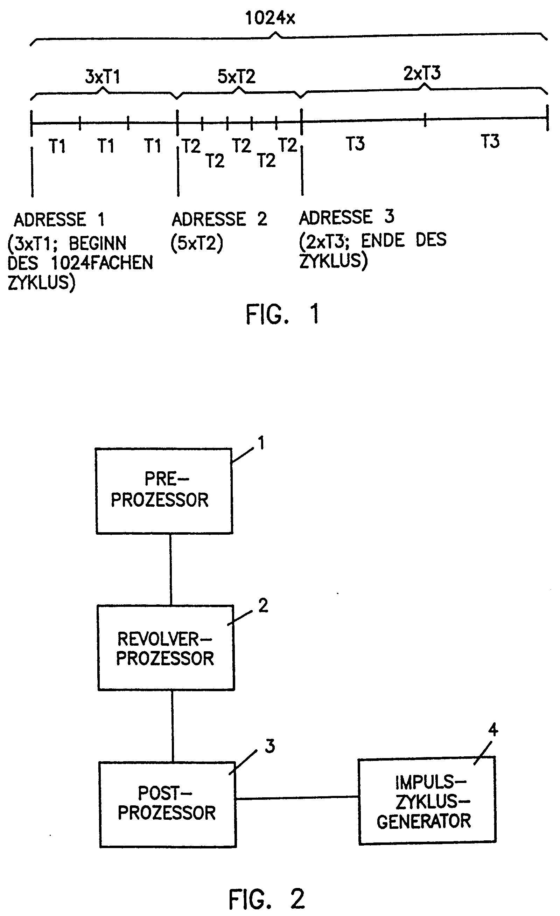

Fig. 1 zeigt in einer schematischen Darstellung eine zu erzeugende Folgen von sich wiederholenden Impulsintervallen: Auf drei Impulsintervalle der Zeitdauer T1 (3 x T1) folgen fünf Impulsintervalle der Zeitdauer T2 (5 x T2) und zwei Impulsintervalle der Zeitdauer T3 (2 x T3). Diese Impulsintervallfolge 3 x T1 - 5 x T2 - 2 x T3 soll 1024fach wiederholt werden (was durch 1024 x angedeutet ist). Es sei angenommen, daß der Faktor 3 sowie der Wert der Zeitdauer T1 unter der Adresse 1, daß der Faktor 5 der Wert der Zeitdauer T2 unter der Adresse 2 und daß der Faktor 2 sowie der Wert der Zeitdauer T3 unter der Adresse 3 gespeichert ist, und daß der Beginn und das Ende des 1024fachen Wiederholungszyklusses unter Adresse 1 und 3 vermerkt ist.

Fig. 2 zeigt eine schematische Darstellung zur computergesteuerten Erzeugung einer Impulsintervallfolge gemäß Fig. 1 unter Verwendung eines Pre-Prozessors 1, eines sogenannten Revolver-Prozessors 2, eines Post-Prozessors 3 und eines Impulszyklusgenerators 4.

Die Aufgaben für die zu erzeugende Impulsintervallfolge sind im Pre-Prozessor 4 verfügbar (gespeichert).

In Hochgeschwindigkeits-Prozessorefl nach dem Stand der Technik ist aus Geschwindigkeitsgründen eine indirekte Adressierung nicht möglich - solche Hochgeschwindigkeits-Prozessoren werden deshalb zumeist in Maschinensprache und nicht in einer höheren Programmiersprache programmiert (welche von der indirekten Adressierung Gebrauch macht).

Der Pre-Prozessor im erfindungsgemäßen System läßt jedoch eine höhere Programmiersprache mit indirekter Adressierung zu. Die sich dadurch ergebenden Nachteile werden durch andere Maßnahmen - wie später beschrieben - vermieden und durch weitere Vorteile überboten. Der Pre-Prozessor liefert neben Steuerinformation an den Revolver-Prozessor Datensätze mit Angaben zur Anzahl unmittelbar aufeinanderfolgender Impulsintervalle gleicher Zeitdauer (wie 3 x T1, 5 x T2, 2 x T3) und Angaben zur zyklischen Wiederholung (z. B. 1024 mal) von Impulsintervallfolgen, alles jedoch ohne indirekte Adressierung.

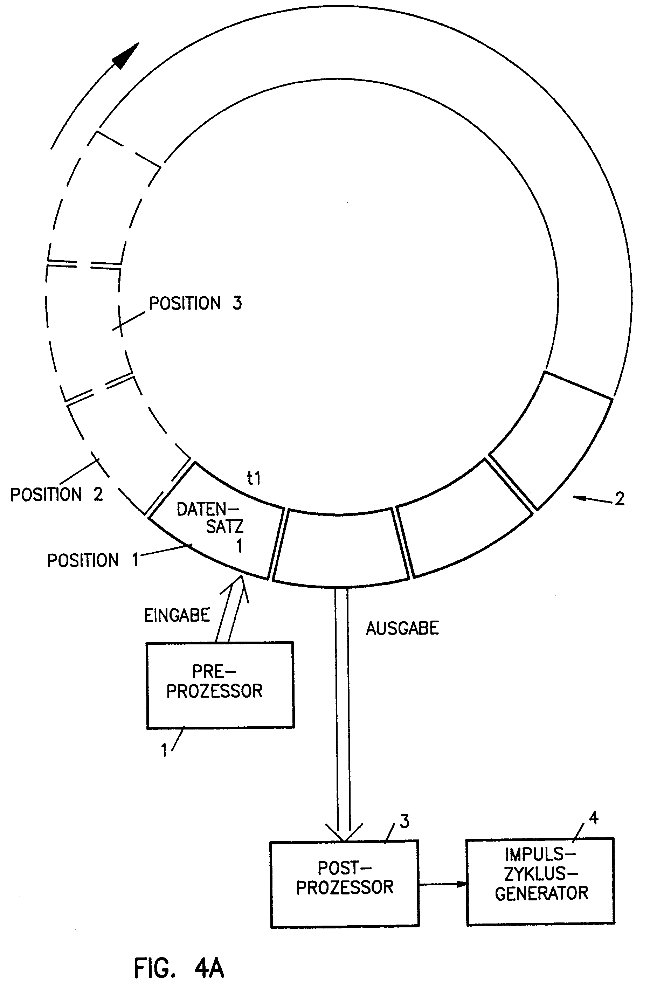

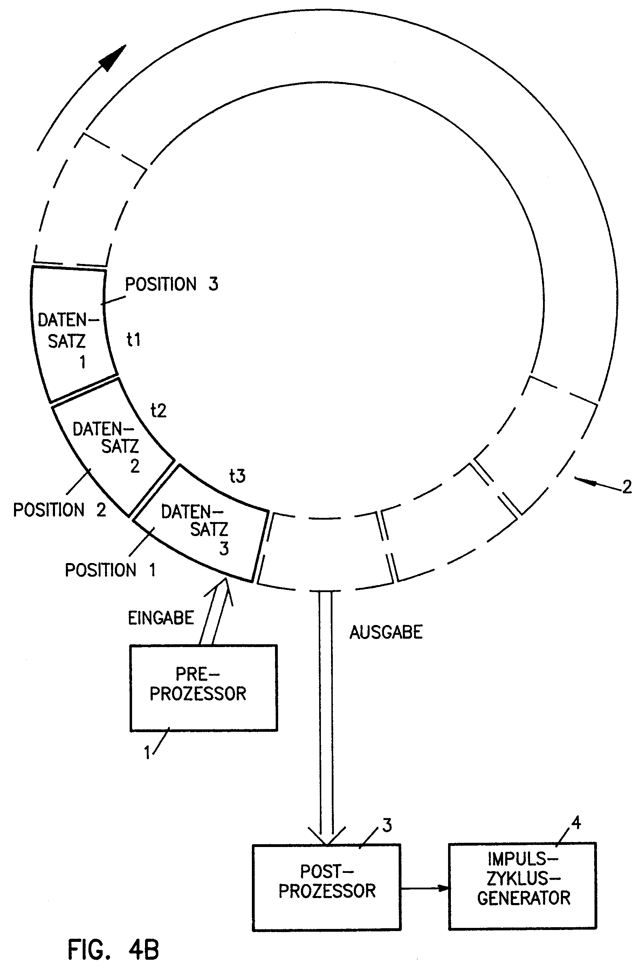

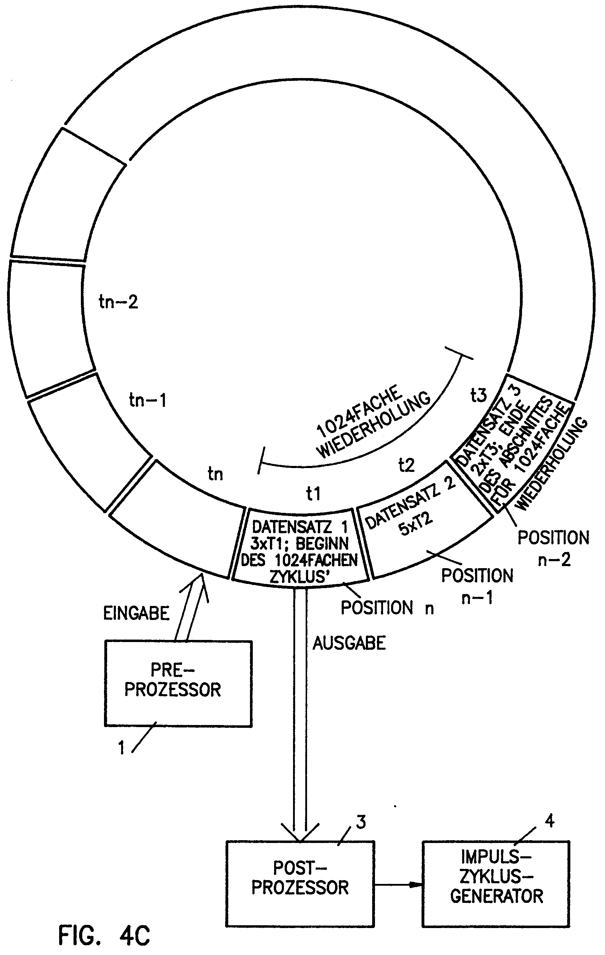

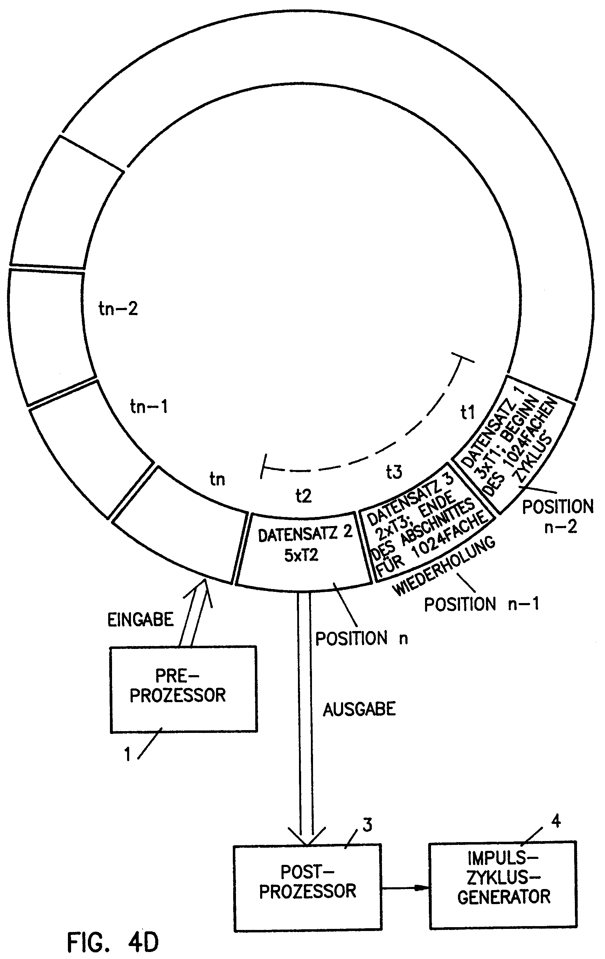

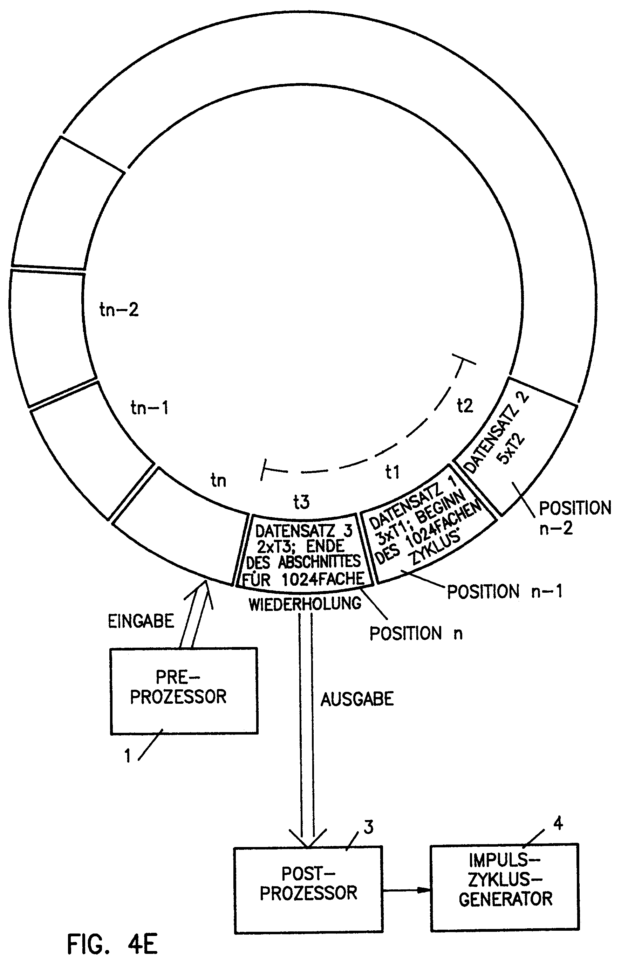

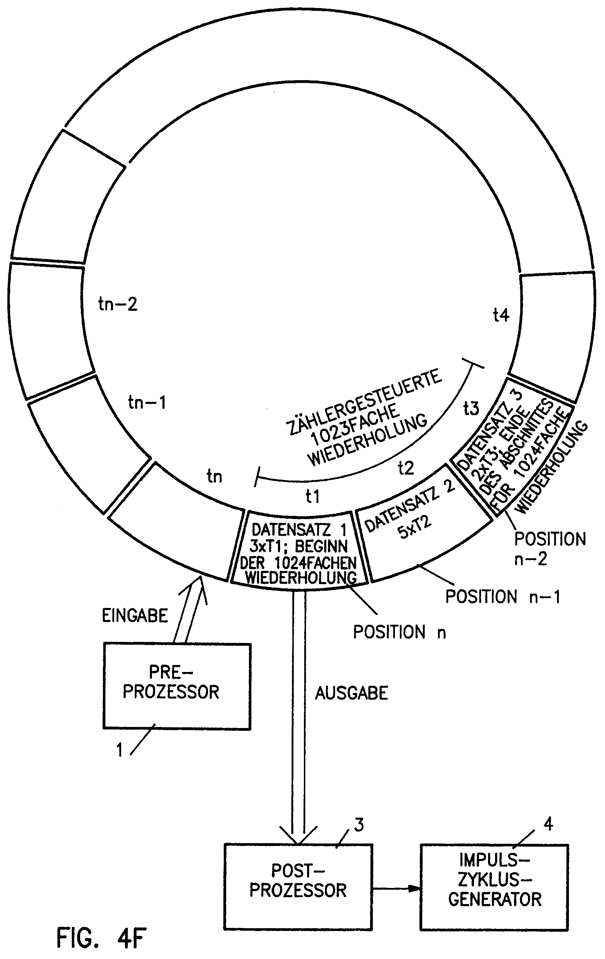

Die Funktion des Revolver-Prozessors 2 wird detailliert im Zusammenhang mit den Figuren 4A bis 4F beschrieben. Sobald der Datensatz 1 über die Eingabestation nach n-Takten in die gedachte n-te Stufe (Ausgabestation) des Revolver-Prozessors gelangt ist, wird im gegebenen Beispiel die weitere Eingabe von Daten an der Eingabestation solange unterbrochen, bis die Ausgabe der 1024fachen Wiederholung des Impulsintervallabschnittes 3 x T1, 5 x T2, 2 x T3 abgeschlossen ist. Danach wird die Dateneingabe und stufenweise Fortschaltung der Information (in Pfeilrichtung der Fig. 4) fortgesetzt. Während der 1024fachen Wiederholung des Impulsintervallabschnittes ist zwar die Dateneingabe vom Pre-Prozessor 1 an den Revolver-Prozessor 2 gestoppt, doch diese Zeit kann vom Pre-Prozessor 1 für die indirekte Adressierung (Durchführung von "Pointer"-Adreßinstruktionen) im Vorfeld der Ausgabe von Datensätzen an den Revolver-Prozessor genutzt werden.

Auf diese Art und Weise treten im Gesamtsystem nach Fig. 2 nach Überwindung der Anlaufphase, nämlich des einmaligen Ladens aller Stufen des Revolver-Prozessors 2 die für die Durchführung von "Pointer"-Adreßinstruktionen erforderlichen Zeiten nicht mehr zeitbestimmend in Erscheinung.

So kommt dem in Fig. 2 mit 1 bezeichneten Pre-Prozessor eine besondere funktionelle Aufgabe zu. Wie bereits erwähnt, liefert er dem Revolver-Prozessor 2 insbesondere Datensätze in sequentieller Folge.

Eine solche einfache Funktion könnte allerdings auch von einfacheren Einheiten als gerade einem Prozessor wahrgenommen werden, wenn nicht einer besonderen Anforderung Genüge getan werden muß, die nur durch einen Prozessor erfüllt werden kann. Sie resultiert aus der insbesondere bei der Erzeugung von Impulsintervallfolgen für Testzwecke erforderlichen Adressierung über variierbare "Pointer" einer indirekten Adressierung. Ohne solche "Pointer" würde z. B. nur von einer Datensatzadresse zu einer anderen verzweigt werden können, z. B. von

der Adresse A1 (dort steht der Datensatz 1),

zur Adresse A2 (dort steht der Datensatz 2) und danach

zur Adresse A3 (dort steht der Datensatz 3), etc.

Vielfach soll jedoch zwischenzeitlich auf eine "Pointer"-Adresse AX (dort steht ein vom Programm variierbarer Adreßwert) verzweigt werden. Dieser Adreßwert könnte bei der ersten Ausführung des Verzweigungsbefehls den Wert für die Adresse 10, und bei der zweiten Ausführung den um z. B. zehn erhöhten Wert, dann also hier die Adresse 20 enthalten.

Aufgabe des Pre-Prozessors 1 ist es, "Pointer"-Adresseninstruktion vom Revolver-Prozessor 2 fernzuhalten, solche Instruktionen selbst auszuführen, und an den Revolver-Prozessor 2 lediglich sequentiell Adressen zu liefern, unter denen die Datensätze gespeichert sind.

Die Figuren 4A - 4F zeigen eine schematische Darstellung vom Funktionsablauf des Revolver-Prozessors; Fig. 4A zur Taktzeit t1. Diese vereinfachte Darstellung macht davon Gebrauch, die Datensätze (sie enthalten Angaben wie 3 x T1, Beginn oder Ende eines Wiederholungszyklus) als Inhalt der Magazinkammern eines sich in Pfeilrichtung drehenden "Revolver"-Prozessors zu interpretieren. Der Pre-Prozessor liefert die Datensatze an die Eingabestation. Die Ausgabe von Datensätzen erfolgt an der mit Ausgabe gekennzeichneten Station an den Post-Prozessor 3, von dem aus die Information an den Impulszyklusgenerator 4 weitergegeben wird. Der Revolver-Prozessor soll n Stufen ("Revolvermagazinkammern") zur Aufnahme der Datensätze aufweisen. Zum Zeitpunkt der Taktzeit t1 erfolgt die Eingabe des Datensatzes 1 vom Pre-Prozessor 1 in den Revolver-Prozessor 2. Dieser Datensatz 1 enthält, wie bereits erwähnt, Informationen aus der Adresse 1 des Pre-Prozessors: 3 x T1 und Beginn des 1024fachen Wiederholungszyklusses. Mit jedem weiteren Takt bewegt sich der Inhalt der "Stufen des Revolver-Prozessors" in angegebener Pfeilrichtung um eine Stufe weiter und mit jedem neuen Takt wird auch ein neuer Datensatz vom Pre-Prozessor 1 an der Eingabestation in den Revolver-Prozessor 2 eingegeben.

In Fig. 4B ist der Status des Revolver-Prozessors unter Berücksichtigung der Taktzeiten t1, t2 und t3 dargestellt. Der Datensatz 1 hat sich aus der Position 1 in Fig. 4A in die Position 3 in Fig. 4B weiterbewegt. Der zwischenzeitlich zum Takt t2 eingegebene Datensatz 2 ist über die Eingabestation (Position 1) in Position 2 vorgerückt, während zum Takt-Zeitpunkt t3 der Datensatz 3 in die Position 1 eingegeben wird.

Die vom Pre-Prozessor an den Revolver-Prozessor ausgegebenen Datensätze enthalten keine Verzweigungsoperationen u. ä. mehr. Die eigentliche Aufgabe des Pre-Prozessors liegt darin, den ursprünglichen Datenstrom, in welchem noch Verzweigungen auftreten, dahingehend zu prozessieren, daß an den Revolver-Prozessor nur noch Datensätze (und entsprechende Steuerinformationen wie Beginn-Markierung einer Programm(unter-)schleife über mehrere Adressen; Anzahl der Schleifenzyklen; End-Markierung der Programm-(unter-)schleifen; zusätzliche Daten, die letztendlich im Post-Prozessor verarbeitet werden, wie Zykluszeit und Anzahl der Zyklen oder Pointeradresse für Sub-Speicher im Post-Prozessor) ausgegeben werden.

Fig. 4C zeigt eine schematische Darstellung zum Funktionsablauf des Revolver-Prozessors zu einem späteren Zeitpunkt, zu dem der Datensatz 1 die Ausgabestation erreicht hat. Zu diesem Zeitpunkt steht in der Position n des Revolver-Prozessors der Datensatz 1, in der Position n - 1 des Revolver-Prozessors der Datensatz 2 und in der Position n - 2 der Datensatz 3. Die Takte, zu denen diese Datensätze an der Eingabestation eingegeben wurden, sind mit t1, t2, t3 angegeben. Der Datensatz 1 in der Position n enthält u. a. die Information, daß hier der 1024fache Wiederholungszyklus beginnt. Aus dem Datensatz 3 in Position n - 2 geht hervor, daß an dieser Stelle das Zyklus-Ende liegt, der 1024fach zu wiederholen ist. Diese Information veranlaßt eine Datenflußsteuerung für die Datensätze 1, 2 und 3, welche die 1024fache Wiederholung des Zyklusses 3 x T1, 5 x T2 und 2 x T3 berücksichtigt. Zunächst wird, wie in Fig. 4C dargestellt, die Information des Datensatzes 1 an den Post-Prozessor geliefert. Danach (Fig. 4D) wird der Datensatz 2 aus Position n - 1 in die Position n und der Datensatz 3 aus Position n - 2 in Position n - 1 transferiert. Der Datensatz 1 aus Position n in Fig. 4C gelangt in die vom Datensatz 3 freigewordene Position n - 2 (Fig. 4D). Da nunmehr (Fig. 4D) Datensatz 2 in der Ausgabestation Position n steht, wird dessen Information an den Post-Prozessor geliefert. Danach findet wieder (wie in Fig. 4E dargestellt) eine weitere zyklische Verschiebung der Datensätze dahingehend statt, daß nunmehr der Datensatz 3 aus Position n - 1 (Fig. 4D) in Position n (Fig. 4E) gelangt, der Datensatz 1 aus Position n - 2 (Fig. 4D) in Position n - 1 (Fig. 4E) und der Datensatz 2 aus Position n (Fig. 4F) in Position n - 2 (Fig. 4D). Zu dem in Fig. 4D dargestellten Zeitpunkt wird in der Ausgabestation der Datensatz 2 in den Post-Prozessor transferiert. Danach erfolgt (wie aus Fig. 4E hervorgeht) eine erneute zyklische Verschiebung der Datensätze 1, 2 und 3 analog zum Vorhergehenden, so daß, wie aus Fig. 4F zu ersehen ist, nunmehr der Datensatz 1 wieder in der Ausgabestation Position n steht. Zu diesem Zeitpunkt ist von der 1024fachen Wiederholung des Zyklusses 3 x T1, 5 x T2, 2 x T3, bereits die erste Wiederholung vollzogen, so daß nur noch eine nachfolgende 1023fache Wiederholung (zählergesteuert) abzuarbeiten ist. Während der Zykluswiederholung im Revolver-Prozessor ist die Dateneingabe vom Pre-Prozessor in den Revolver-Prozessor gesperrt. Die Dateneingabe kann erst dann fortgeführt werden, wenn die 1024fache Wiederholung des Zyklusses 3 x T1, 5 x T2 und 2 x T3 vollzogen wurde. Mit jeder "Verschiebung" an der Ausgabestation des Revolver-Prozessors wird deren Inhalt ohne Wiederholungsangaben in die erste Stufe des Post-Prozessors übertragen; damit ist die übertragene Information serialisiert und weiter vereinfacht.

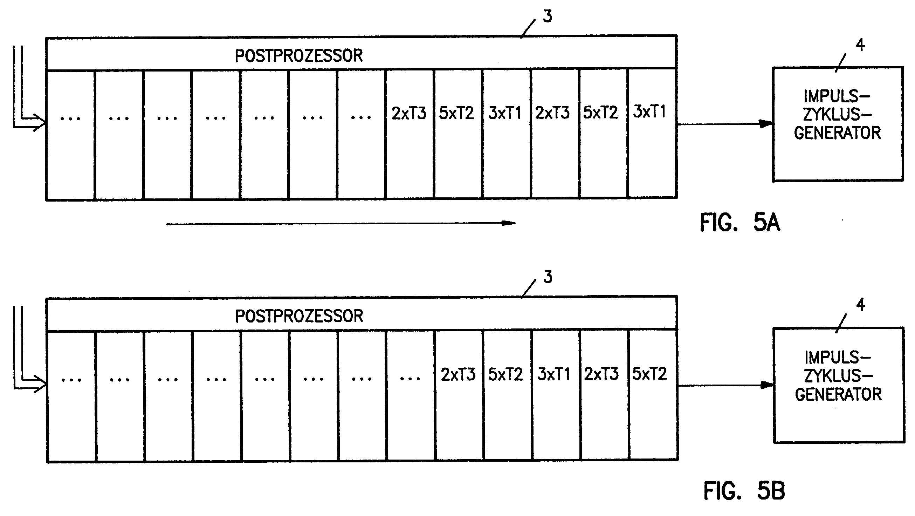

In den Figuren 5A und 5B ist eine schematische Darstellung des Datenflusses im Post-Prozessor 3 gezeigt. In vereinfachter Darstellung erhält der Post-Prozessor über die Ausgabestation des Revolver-Prozessors 2 nacheinander die einzelnen Datensätze (z. B. 3 x T1, 5 x T2, 2 x T3. Diese Informationen werden datensatzspezifisch wie in einem Schieberegister durch einzelne Stufen des Post-Prozessors hindurchgeschoben. So bald, wie in Fig. 5A dargestellt, die Information 3 x T1 aus dem Datensatz 1, nämlich drei aufeinanderfolgende Impulsintervalle mit der Impulsdauer T1, den Ausgang des Post-Prozessors erreicht, wird diese Information in den Impulszyklusgenerator 4 übertragen, in dem zählergesteuert die Erzeugung dieser Impulszyklen erfolgt. Der vorzugsweise Aufbau eines solchen Impulszyklusgenerators ist in der deutschen Patentanmeldung P 28 29 709 vom gleichen Anmelder (Aktenzeichen des Anmelders: GE 978 014) beschrieben.

Der Post-Prozessor hat jedoch nicht nur die Funktion eines Schieberegisters zu erfüllen, er muß (und dies erst erfordert einen Prozessor) Verzweigungen auf bestimmte Adressen durchführen können. Für die Vergabe 3 x T1 muß der an den Post-Prozessor 3 angeschlossene Impulsintervallgenerator 4 dreimal nacheinander mit dem Wert für T1 beliefert werden, die unter einer bestimmten Adresse des Post-Prozessors gespeichert ist.

Mit dem nächsten Takt des Post-Prozessors ergibt sich eine Situation, wie sie in Fig. 5B schematisch wiedergegeben ist. Am Ausgang des Post-Prozessors steht jetzt die aus dem Datensatz 2 stammende Information, nämlich 5 x T2. Diese Information wird nunmehr an den Impulszyklusgenerator 4 geliefert, um im Anschluß an die dreimalige Erzeugung von Impulsintervallen mit der Impulsdauer T1 nun eine fünfmalige Erzeugung von Impulsintervallen mit jeweils der Impulsdauer T2 anzuschließen. Dieser Vorgang wird danach fortgeführt mit der zweimaligen Erzeugung von Impulsintervallen mit der Impulsdauer T3, wiederum gefolgt von einer dreimaligen Erzeugung von Impulsintervallen mit der Impulsdauer T1, einer fünfmaligen Erzeugung von Impulsintervallen mit der Impulsdauer T2, einer zweimaligen Erzeugung von Impulsintervallen mit der Impulsdauer T3 usw. bis insgesamt die 1024fache Wiederholung des Zyklusses 3 x T1, 5 x T2 und 2 x T3 vollzogen ist.

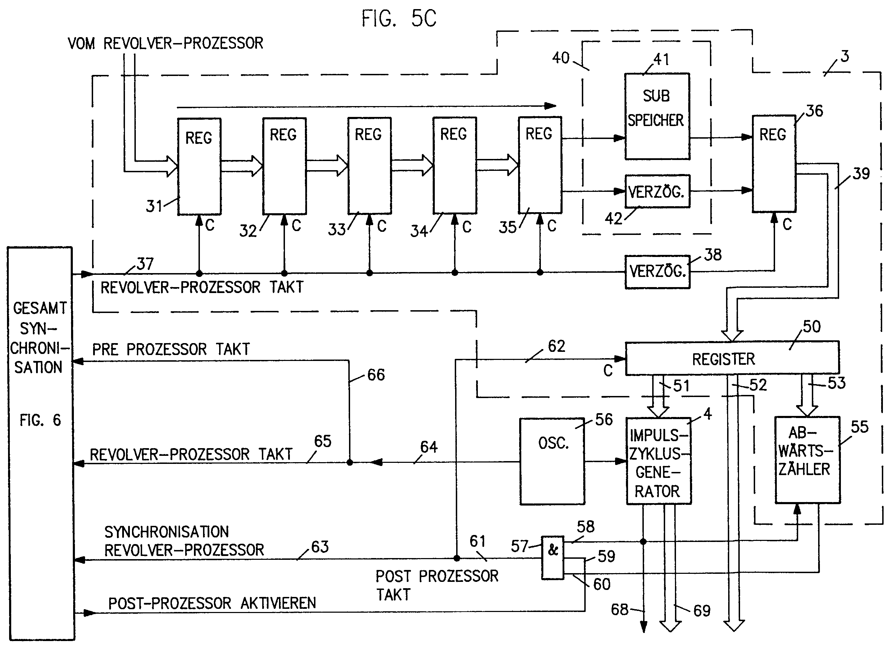

Fig. 5C zeigt eine detaillierte funktionelle Darstellung des Post-Prozessors 3 in Verbindung mit dem Impulszyklusgenerator 54.

Die vom Revolver-Prozessor 2 stammenden Datensätze (sie enthalten neben entsprechender Steuerinformation jeweils Anzahl und Zeitdauer von Impulsintervallen, z. B. 3 x T1) werden taktgetrieben (c) in Pfeilrichtung durch die Registerstufen 31, 32, 33, 34, 35 und 36 geschoben. Die Taktung dieser Registerstufen erfolgt auf der Leitung 37 mit dem Revolver-Prozessortakt. Den aus dem Stand der Technik bekannten programmiertechnischen Vorteil des Sub-Speichers 41 auch hier nutzend, kann zwischen zwei Registerstufen (hier 35 und 36) die Zwischenschaltung 40 eines Sub-Speichers 41 und eines Verzögerungsgliedes 42 erfolgen. Über den Sub-Speicher 41 werden bestimmte Informationen geleitet: z. B. Zykluszeit, Anzahl der gleichen aufeinanderfolgenden Zyklen. Andere Informationen (vorzugsweise Steuerdaten, z. B. Lese-/Schreib-Befehle, Steuersignale für eventuell nachgeschaltete Prozessoren, wie Signal-Generator, Zeitgebungs-Generator, etc.) werden über das Verzögerungsglied 42 direkt auf die nächste Registerstufe geleitet. Die Verzögerung dient dem Ausgleich der durch den Sub-Speicher 41 bedingten zusätzlichen Zugriffszeit. Die durch die Zwischenschaltung 40 bedingte Zeitverzögerung zwischen den Registerstufen 35 und 36 wird durch ein Verzögerungsglied 38 ausgeglichen. In den Registerstufen 31 bis 35 sind insbesondere die Adressen der Speicherplätze enthalten, unter denen die gewünschten Werte, z. B. die Impulsintervalldauer, gespeichert sind. Ein Zugriff auf einen solchen Wert erfolgt über die im Register genannte Speicheradresse. Das mit 50 bezeichnete Register des Post-Prozessors 3 ermöglicht eine erfindungsgemäße äußerst schnelle Verarbeitung. Es enthält nicht, wie die vorgenannten Registerstufen 31 - 35 Adreßangaben, sondern u. a. die unter diesen Adressen aufrufbaren Werte, z. B. den Wert für die Impulsdauer T1. Muß im Laufe der Verarbeitung mehrfach auf diesen Wert zugegriffen werden, so kann dies jetzt direkt und nicht indirekt über Speicherplatzadressen geschehen. Auf diese Weise ergibt sich eine vorteilhafte Zeitersparnis. Von diesem Register 50 (es soll beispielsweise Angaben wie 3 x T1 und entsprechende Steuerdaten enthalten) werden der Wert für T1 über die Leitung 51 an den Impulszyklusgenerator 4 und der Faktor 3 über die Leitung 53 an den Abwärtszähler 55, sowie die Steuerdaten über die Leitung 52 an hier nicht dargestellte Unter-Prozessoren (z. B. Signal-Generator, Zeitgebungs-Generator) geliefert. Ein Oszillator 56 liefert den Takt für den Impulszyklusgenerator 4 und über die Leitung 64, 65 an den Revolver-Prozessor 2. Wahlweise kann dieser Takt auch über die Leitung 66 für den Pre-Prozessor verwendet werden, sofern er keinen eigenen freilaufenden Oszillator hat. Der Ausgang 61 der Undschaltung 57 mit den drei Eingängen

59 Post-Prozessor aktivieren

60 Zählerstand 0 beim Abwärtszähler 55

58 Impulsintervall vom Zyklusgenerator 4 erzeugt,

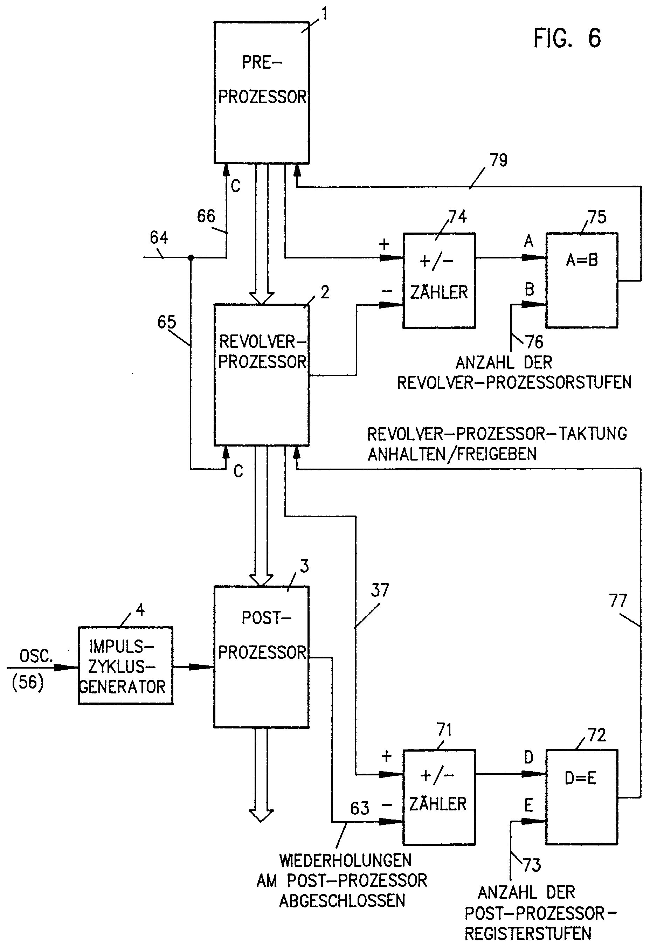

wird benutzt, um das Register 50 über die Leitung 62 zu takten und den Revolver-Prozessor über die Leitung 63 zu synchronisieren. Alle Leitungen 65, 66 und 63 führen zu einer Synchronisationsschaltung für das Gesamtsystem, welche in Fig. 6 wiedergegeben ist.

Fig. 6 zeigt eine schematische Darstellung zur Synchronisation des aus Pre-, Revolver- und Post-Prozessor bestehenden Gesamtsystems. Wie in Fig. 2, ist der Pre-Prozessor mit 1, der Revolver-Prozessor mit 2 und der Post-Prozessor mit 3 gekennzeichnet. Die Informationsflüsse der Prozessoren sind schematisch durch breite Pfeile angedeutet. Die Taktung des Pre-Prozessors 1 und des Revolver-Prozessors 2 erfolgt über die Leitung 66 bzw. 65 (siehe Fig. 5). Die Ausgabe-Takte des Revolver-Prozessors werden auf Leitung 37 einem Auf-/Abwärtszähler 71 zugeführt.

Diese Takte inkrementieren diesen Zähler, während Ausgangs-Signale des Post-Prozessors auf Leitung 63 diesen Zähler dekrementieren. Ein Signal auf Leitung 63 bedeutet, daß Wiederholungen am Post-Prozessor abgeschlossen wurden, d. h., daß z. B. die Angabe 3 x T1 zu einer dreimaligen Wiederholung der Erzeugung eines Impulsintervalles mit der Impulsdauer T1 geführt hat. Der Zählerstand des Zählers 71 wird als Wert D einer Vergleichsschaltung 72 zugeführt, in der dieser Wert mit dem Wert E auf Leitung 73 verglichen wird, der für die Anzahl der Registerstufen im Post-Prozessor steht. Sobald die Vergleichsschaltung 72 eine Übereinstimmung zwischen D und E feststellt, wird über ihre Ausgangsleitung 77 die Revolver-Prozessortaktung angehalten. In den Fällen D < E wird die Revolver-Prozessortaktung wieder freigegeben.

Die Ausgabetakte des Pre-Prozessors 1 werden einem Auf-/Abwärtszähler 74 zugeführt. Diese Takte inkrementieren den Zähler, während die Ausgangstaktsignale des Revolvers diesen Zähler 74 dekrementieren. Der Wert A des Zählers 74 wird einer Vergleichsschaltung 75 zugeführt, in der dieser Wert mit dem Wert B auf Leitung 76, der Anzahl der Revolver-Prozessorstufen (76) verglichen wird. Bei Gleichheit wird über die Ausgangsleitung 79 der Vergleichsschaltung 75 die Pre-Prozessortaktung angehalten. In den Fällen A < B wird diese Taktung wieder freigegeben.

Aus dem Vorstehenden geht hervor, daß die Synchronisation der Prozessoren von "unten nach oben" erfolgt, d. h., der Post-Prozessor 3 bestimmt den Zeitpunkt, in dem der Revolver-Prozessor 2 Daten an den Post-Prozessor 3 nachliefern darf und der Revolver-Prozessor 2 bestimmt den Zeitpunkt, in dem der Pre-Prozessor 1 Daten an den Revolverprozessor 2 nachliefern kann.

## Patentansprüche

1.  Verfahren zur computergesteuerten Erzeugung von Impulsintervallfolgen mit Abschnitten sich wiederholender Impulsintervalle, gekennzeichnet durch folgende Schritte:
    Vorgabe von Daten (Fig. 1) zur Kennzeichnung der Anzahl und der Zeitdauer unmittelbar aufeinanderfolgender gleicher Impulsintervalle innerhalb einer Impulsintervallfolge;
    Vorgabe von Daten (Fig. 1) zur Kennzeichnung der Anzahl von Wiederholungen eines Abschnittes von Impulsintervallen innerhalb einer Impulsintervallfolge unter Markierung des ersten und letzten Impulsintervalles innerhalb des zu wiederholenden Abschnittes;
    taktgesteuerter, sequentieller Umlauf dieser Daten in n-Stufen (n = 1, 2, 3, ... bis n) eines Prozessors (2) mit einer Dateneingabestation an der ersten und einer Datenausgabestation an der nten Stufe;
    daß die durch taktgesteuerten Umlauf die Ausgabestation erreichenden Daten an einen Impulsintervallgenerator (4) zur Erzeugung der Impulsintervallfolge geliefert werden, wobei beim Auftreten einer Kennzeichnung für den Beginn eines zu wiederholenden Abschnittes in der Ausgabestation der taktgesteuerte Umlauf unterbrochen wird, wonach prozessorgesteuert die Stufen mit den Daten vom ersten bis zum letzten Impulsintervall des zu wiederholenden Abschnittes entsprechend der Anzahl der Wiederholungen zyklisch durchlaufen werden;
    wobei für jede durchlaufende Stufe deren Daten an einen Impulsintervallgenerator (4) geliefert werden und
    daß nach Beendigung des zyklischen Durchlaufes die Dateneingabe an der Eingabestation und der Umlauf der Daten fortgesetzt wird.

2.  Verfahren nach Anspruch 1, gekennzeichnet durch eine vorgeschaltete prozessorgesteuerte (1) Aufbereitung der unter Einschluß indirekter Adressierung vorgegebenen Daten in solche, die nur noch einer direkten Adressierung unterliegen.

3. Verfahren nach Anspruch 1, gekennzeichnet durch eine nachgeschaltete prozessorgesteuerte (3) Aufbereitung der an den Impulsgenerator (4) lieferbaren Daten für eine direkte Adressierung der Angaben zur Anzahl gleicher unmittelbar aufeinanderfolgender Impulsintervalle gleicher Zeitdauer und zu dieser Zeitdauer selbst, ohne daß auf diese Angaben über eine indirekte Adreßzuweisung zugegriffen wird.

4. Verfahren nach einem der Ansprüche 1 bis 3, gekennzeichnet durch die Anwendung zum Austesten von schnellen Speicherprodukten oder logischen Schaltungen.

5. Anordnung zur computergesteuerten Erzeugung von Impulsintervallfolgen mit Abschnitten sich wiederholender Impulsintervalle, gekennzeichnet durch einen Prozessor (2) (Revolver-Prozessor)
zur Verarbeitung
vorgegebener Daten zur Kennzeichnung der Anzahl K (K = 1, 2, 3 ...) und Zeitdauer T unmittelbar aufeinanderfolgender gleicher Impulsintervalle innerhalb einer Impulsintervallfolge und
vorgegebener Daten zur Kennzeichnung der Anzahl von Wiederholungen eines Abschnittes von Impulsintervallen innerhalb einer Impulsintervallfolge unter Markierung des ersten und letzten Impulsintervalles innerhalb des zu wiederholenden Abschnittes
durch einen taktgesteuerten, sequentiellen Umlauf der vorgegebenen Daten (n-Stufen (n = 1, 2, 3, ... bis n) des Prozessors (2), der eine Dateneingabestation an der ersten und einer Datenausgabestation an der n-ten Stufe aufweist,
wobei
die durch taktgesteuerten Umlauf die Ausgabestation erreichenden Daten an einen Impulsintervallgenerator (4) in an sich bekannter Weise zur Erzeugung der Impulsintervallfolgen lieferbar sind,
beim Auftreten einer Kennzeichnung für den Beginn eines zu wiederholenden Abschnittes in der Ausgabestation der taktgesteuerte Umlauf unterbrochen wird, wonach prozessorgesteuert die Stufen mit den Daten vom ersten bis zum letzten Impulsintervall des zu wiederholenden Abschnittes entsprechend der Anzahl der Wiederholungen zyklisch durchlaufen werden und für jede durchlaufende Stufe, deren Daten an der Ausgabestation an den Impulsintervallgenerator (4) geliefert werden und
daß nach Beendigung des zyklischen Durchlaufes die Dateneingabe an der Eingabestation und der Umlauf der Daten fortgesetzt wird.

6. Anordnung nach Anspruch 5, dadurch gekennzeichnet, daß dem Prozessor 2 (Revolver-Prozessor) ein Prozessor (1) (Pre-Prozessor) vorgeschaltet ist zur Vergabe der Daten zur Kennzeichnung der Anzahl K (K = 1, 2, 3 ...) und Zeitdauer T unmittelbar aufeinanderfolgender, gleicher Impulsintervalle innerhalb einer Impulsintervallfolge an den Prozessor (2) durch direkte Adressierung der Speicherplätze, an denen die Adressen für die Anzahl K und die Zeitdauer T gespeichert sind.

7. Anordnung nach Anspruch 5, dadurch gekennzeichnet, daß dem Prozessor (2) (Revolver-Prozessor) ein Prozessor (3) (Post-Prozessor) zur Aufbereitung der für den Impulsgenerator (4) zu liefernden Daten nachgeschaltet ist, und daß dieser Prozessor (3) ein Register aufweist für eine direkte Adressierung der Angaben der Anzahl K und der Zeitdauer T.

FIG. 1

FIG. 2

FIG. 3

FIG. 4A

POSITION 3

DATEN-
SATZ
1

t1

t2

DATEN-
SATZ
2

POSITION 2

t3

DATEN-
SATZ
3

POSITION 1

2

EINGABE

AUSGABE

PRE-
PROZESSOR

1

POST-
PROZESSOR

3

IMPULS-
ZYKLUS-
GENERATOR

4

FIG. 4B

tn−2

tn−1

tn

1024FACHE
WIEDERHOLUNG

t3

t1

DATENSATZ 1
3xT1; BEGINN
DES 1024FACHEN
ZYKLUS'

t2

DATENSATZ 2
5xT2

DATENSATZ 3
2xT3; ENDE
DES ABSCHNITTES
FÜR 1024FACHE
WIEDERHOLUNG

POSITION n

POSITION
n−1

POSITION
n−2

EINGABE

AUSGABE

PRE-
PROZESSOR

1

POST-
PROZESSOR

3

IMPULS-
ZYKLUS-
GENERATOR

4

## FIG. 4C

EP 0 579 857 A1

tn-2

tn-1

tn

t1

t2

t3

DATENSATZ 1
3xT1: BEGINN
DES 1024FACHEN
ZYKLUS

POSITION
n-2

DATENSATZ 3
2xT3: ENDE
DES ABSCHNITTES
FÜR 1024FACHE
WIEDERHOLUNG

DATENSATZ 2
5xT2

POSITION n-1

POSITION n

EINGABE

PRE-
PROZESSOR

1

AUSGABE

POST-
PROZESSOR

3

IMPULS-
ZYKLUS-
GENERATOR

4

FIG. 4D

14

FIG. 4E

FIG. 4F

FIG. 5A

FIG. 5B

FIG. 5C

VOM REVOLVER-PROZESSOR

REG 31
REG 32
REG 33
REG 34
REG 35
REG 36

SUB SPEICHER 41

VERZÖG. 42

VERZÖG. 38

REVOLVER-PROZESSOR TAKT 37

39

40

3

REGISTER 50

53

AB-WÄRTS-ZÄHLER 55

52

51

IMPULS-ZYKLUS-GENE-RATOR 4

OSC. 56

& 57

58

59

60

69

68

62

64

66

61

65

63

PRE PROZESSOR TAKT

REVOLVER-PROZESSOR TAKT

SYNCHRONISATION REVOLVER-PROZESSOR

POST PROZESSOR TAKT

POST-PROZESSOR AKTIVIEREN

GESAMT SYN-CHRONI-SATION

FIG. 6

FIG. 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-4 806 852 (SWAN ET AL.) <br> * das ganze Dokument * <br> --- | 1,5 | H03K3/78 |
| A | US-A-4 928 278 (OTSUJI ET AL.) <br> --- | | |
| A | US-A-4 287 594 (SHIRASAKA) <br><br> ----- | | |

|  |  |
|---|---|
| | **RECHERCHIERTE SACHGEBIETE (Int. Cl.5)** <br><br> H03K <br> G06F <br> G01R |

Der vorliegende Recherchenbericht wurde für alle Patentansprüche erstellt

| Recherchenort | Abschlußdatum der Recherche | Prüfer |
|---|---|---|
| DEN HAAG | 22 MAERZ 1993 | SEGAERT P.A.O.M. |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus andern Gründen angeführtes Dokument
...........................................................................
& : Mitglied der gleichen Patentfamilie, übereinstimmendes
   Dokument